(19) Europäisches Patentamt
European Patent Office
Office européen des brevets

(11) **EP 3 798 660 A1**

(12) **EUROPÄISCHE PATENTANMELDUNG**

(43) Veröffentlichungstag:
**31.03.2021 Patentblatt 2021/13**

(51) Int Cl.:
***G01R 33/54*** *(2006.01)*

(21) Anmeldenummer: **19199598.4**

(22) Anmeldetag: **25.09.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Healthcare GmbH**
**91052 Erlangen (DE)**

(72) Erfinder:
• **Feiweier, Thorsten**
  **91099 Poxdorf (DE)**
• **Köhler, Michael**
  **90408 Nürnberg (DE)**

(54) **VERFAHREN ZUR BEREITSTELLUNG VON EINSTELLUNGSPARAMETERSÄTZEN FÜR EINE MAGNETRESONANZEINRICHTUNG, VERFAHREN ZUM BETRIEB EINER MAGNETRESONANZEINRICHTUNG, BEREITSTELLUNGSEINRICHTUNG, MAGNETRESONANZEINRICHTUNG UND COMPUTERPROGRAMM**

(57) Verfahren zur Bereitstellung von Einstellungsparametersätzen (3) für wenigstens ein durch Protokollparameter beschriebenes Messprotokoll zur Aufnahme von Magnetresonanzdaten mit einer Magnetresonanzeinrichtung, wobei der Einstellungsparametersatz (3) vorgegebene Werte für wenigstens einen Teil der Protokollparameter und/oder vorgegebene Wertebereiche für wenigstens einen Teil der Protokollparameter umfasst, wobei je ein Einstellungsparametersatz (3) für wenigstens zwei Temperaturzustandsklassen der Magnetresonanzeinrichtung unter Verwendung eines die Entwicklung des Temperaturzustands wenigstens einer Komponente (15) der Magnetresonanzeinrichtung, die bei der Ausführung des Messprotokolls erwärmt wird, während der Ausführung des Messprotokolls beschreibenden Temperaturmodells (2) derart ermittelt wird, dass für jeden Starttemperaturzustand, der in der Temperaturzustandsklasse enthalten ist, zu Beginn einer Messung mit einem Messprotokoll, das Protokollparameter gemäß den Vorgaben des Einstellungsparametersatzes (3) nutzt, eine Überhitzung, beschrieben durch Überschreitung einer Grenztemperatur, der wenigstens einen Komponente (15) durch die maximal für eine vorgegebene Wiederholungsanzahl wiederholte Messung mit dem Messprotokoll vermieden wird.

FIG 1

EP 3 798 660 A1

**Beschreibung**

Die Erfindung betrifft ein Verfahren zur Bereitstellung von Einstellungsparametersätzen für wenigstens ein durch Protokollparameter beschriebenes Messprotokoll zur Aufnahme von Magnetresonanzdaten mit einer Magnetresonanzeinrichtung, wobei der Einstellungsparametersatz vorgegebene Werte für wenigstens einen Teil der Protokollparameter und/oder vorgegebene Wertebereiche für wenigstens einen Teil der Protokollparameter umfasst. Daneben betrifft die Erfindung ein Verfahren zum Betrieb einer Magnetresonanzeinrichtung, eine Bereitstellungseinrichtung, eine Magnetresonanzeinrichtung und ein Computerprogramm.

Im klinischen Betrieb ist die Magnetresonanzbildgebung (MRI) als medizinische Bildgebungsmodalität inzwischen etabliert. Es existieren eine Vielzahl möglicher Bildgebungstechniken, in denen im Rahmen von Messprotokollen eine oder mehrere unterschiedliche Magnetresonanzsequenzen in einem durch das Messprotokoll vorgegebenen zeitlichen Ablauf genutzt werden können, um Magnetresonanzdaten eines Untersuchungsobjekts, insbesondere eines Patienten, aufzunehmen. Das bedeutet, Protokollparameter, die ein Messprotokoll beschreiben, umfassen insbesondere auch Sequenzparameter der darin verwendeten Magnetresonanzsequenzen.

Die Messprotokolle und Magnetresonanzsequenzen nutzen verschiedene Komponenten der Magnetresonanzeinrichtung zur Umsetzung der Bildgebung. Üblicherweise wird wenigstens ein Hochfrequenzpuls zur Anregung des Untersuchungsbereichs ausgestrahlt, wozu eine Hochfrequenzspulenanordnung eingesetzt werden kann, welche auch zum Empfang der entstehenden Magnetresonanzsignale eingesetzt werden kann, falls hierfür nicht eine spezielle Empfangsspulenanordnung, beispielsweise als Lokalspulenanordnung, vorgesehen ist. Die Leistung für auszusendende Hochfrequenzpulse wird üblicherweise mittels eines Hochfrequenzleistungsverstärkers (RFPA) erzeugt. Zur Ortskodierung werden in der Magnetresonanzbildgebung Gradienten eingesetzt, wobei die entsprechenden Gradientenfelder mittels einer entsprechenden Gradientenspulenanordnung erzeugt werden, die wiederum von einem Gradientenleistungsverstärker (GPA) gespeist wird. Weitere Komponenten der Magnetresonanzeinrichtung umfassen beispielsweise, neben dem selbstverständlich vorhandenen Grundfeldmagneten in der Hauptmagneteinheit, Shimspulenanordnungen, diverse Kühleinrichtungen und dergleichen.

Derartige Komponenten stellen Hardware dar, die aufgrund ihrer Auslegung Leistungsbeschränkungen bezüglich ihres Temperaturzustands aufweisen können. Beispielsweise werden bei gradientenlastigen Magnetresonanzsequenzen eine Vielzahl von Gradientenpulsen benötigt, welche für eine Erwärmung, insbesondere im Gradientenleistungsverstärker selbst, aber auch in anderen Komponenten der Magnetresonanzeinrichtung, führen können. Wird eine Grenztemperatur für derart erwärmte Komponenten, beispielsweise die Gradientenspule oder den Gradientenleistungsverstärker, erreicht, muss die entsprechende Komponente abgeschaltet werden und somit meist die Messung abgebrochenwerden. Die Temperatur soll also eine eine Betriebsgrenze beschreibende Grenztemperatur nicht überschreiten darf. Daher sollen Magnetresonanzsequenzen oder allgemeiner Messprotokolle so ausgelegt werden, dass es möglichst nicht zu einer Überhitzung von Komponenten der Magnetresonanzeinrichtung kommt. Magnetresonanzsequenzen, die eine hohe Gradientenleistung anfordern, sind beispielsweise sogenannte EPI-Sequenzen (Echo Planar Imaging), die beispielsweise im Rahmen der Diffusionsbildgebung häufig wiederholt ausgespielt werden können.

Im Stand der Technik wurde bereits vorgeschlagen, einstellbare Protokollparameter an der Magnetresonanzeinrichtung so stark einzuschränken, dass die Untersuchung, insbesondere ein bestimmtes Messprotokoll, durchgeführt werden kann, ohne dass Hardware-Komponenten zum Schutz abgeregelt beziehungsweise abgeschaltet werden müssen und ohne dass die Bildqualität aufgrund einer Unterschreitung der durch die Magnetresonanzsequenz angeforderten Leistungen beeinträchtigt wird. Aufgrund der komplexen Abhängigkeiten innerhalb der einzelnen Protokollparameter ist die Bestimmung von gerade noch möglichen, die Leistungsfähigkeit der Magnetresonanzeinrichtung vollständig ausnutzenden Werten der Protokollparameter oft nur durch das Ausrollen des vollständigen Messprotokolls beziehungsweise der darin enthaltenen Magnetresonanzsequenzen möglich, bei mehreren Protokollen einer Untersuchung gegebenenfalls auch nur durch Ausrollen des gesamten Untersuchungsverlaufs.

In diesem Kontext wurde es im Stand der Technik bereits vorgeschlagen, den Einfluss von Protokollen auf den Systemzustand bezüglich der Temperatur zu modellieren, beispielsweise über ein Temperaturmodell. Die Idee hierbei ist es, Magnetresonanzsequenzen innerhalb eines derartigen Temperaturmodells auszurollen, um ihren Effekt auf die Temperatur zu simulieren. So ist es möglich, abzuschätzen, wie lange die Magnetresonanzeinrichtung bei einer bestimmten Leistung betrieben werden kann, bevor die Betriebsgrenze erreicht ist. Kühleinrichtungen der Magnetresonanzeinrichtung können in einem Beispiel nur eine endliche Wärmemenge abführen. Wird durch Beanspruchung des Gradientenleistungsverstärkers oder des Hochfrequenzleistungsverstärkers oder anderer Komponenten mehr Wärme zugeführt, als die Kühleinrichtung abführen kann, heizt sich die Magnetresonanzeinrichtung, konkret die Komponente, auf und muss bei Erreichen einer Grenztemperatur abgeschaltet werden. So kann über eine einfache Betrachtung des Temperaturzustands der Magnetresonanzeinrichtung eine Vielzahl von zur Performance der Magnetresonanzeinrichtung beitragenden Aspekten zusammengefasst werden.

Um die Limitierungen bezüglich der Temperatur nicht zu überschreiten, also eine Überhitzung zu vermeiden, werden die Protokollparameter eines Messprotokolls üblicherweise basierend auf empirisch ermittelten Größen gewählt.

Dabei und auch bei Einsatz eines Temperaturmodells ist es bekannt, als Größen vor allem die Maximal-Amplitude aller Gradientenpulse oder Teile der Gradientenpulse einer Magnetresonanzsequenz und/oder die gemittelte Gradientenstärke zu limitieren.

Für die Berechnung einer gemittelten Gradientenstärke kommt vor allem die Mittelung der quadrierten Gradientenstärke in Betracht, da für eine gegebene Gradientenstärke ein gewisser Strom erzeugt werden muss, dessen Quadrat proportional zu einer thermischen Leistung ist, die es gering zu halten gilt. Konkret können dann als gemittelte Gradientenstärken die mittlere quadratische Gradientenstärke Gms ("ms" für Englisch "mean squared"):

$$Gms = \frac{1}{t_d} \int_0^{t_d} G(t)^2 dt \quad , \tag{1}$$

wobei $t_d$ die Länge des Mittelungszeitraums ist und G(t) die zeitabhängige Gradientenstärke ist, oder aber die daraus berechnete Quadratwurzel Grms ("rms" für englisch "root mean squared")

$$Grms = \sqrt{\frac{1}{t_d} \int_0^{t_d} G(t)^2 dt} \tag{2}$$

verwendet werden.

Um den Betrieb der Magnetresonanzeinrichtung ohne Überschreitung der thermischen Limitationen zu gewährleisten, werden also beispielshaft die eben genannten Größen limitiert. Das hat zur Folge, dass die einzelnen Gradientenpulse in ihrer Amplitude beschränkt werden und/oder dass das Messprotokoll bzw. die wenigstens eine enthaltene Magnetresonanzsequenz mit Pausen versehen werden muss, um eine Überhitzung zu vermeiden. Beides kann, insbesondere bei starker Beschränkung, die Messdauer nachteilig verlängern und/oder zu reduzierter Bildqualität führen.

Bisher verwendete Verfahren zielen darauf ab, dass jede Magnetresonanzmessung die thermische Limitierung einhält und auch dann einhalten würde, wenn sie mehrmals wiederholt wird. Diese Langzeitbetrachtung kann als Prinzip der beliebigen Wiederholbarkeit von Messprotokollen bezeichnet werden, was auch unter den Begriff "run once, run ever"-RORE bekannt ist. Das bedeutet, Magnetresonanzsequenzen werden bezüglich der Protokollparameter grundsätzlich so ausgelegt, dass zum einen jede Messung beliebig oft durchgeführt werden kann und zum anderen nicht vom Anfangssystemzustand der Magnetresonanzeinrichtung abhängt. Selbst bei einer aufgeheizten Magnetresonanzeinrichtung kann jedes RORE-Messprotokoll durchgeführt werden, da es nicht zu einer weiteren Netto-Aufheizung führt, die zum Erreichen der Grenztemperatur und somit Überhitzung führen könnte. Dies vereinfacht die Bedienung der Magnetresonanzeinrichtung enorm, hat jedoch zur Folge, dass für viele Messprotokolle unnötig starke Beschränkungen, beispielsweise beschrieben durch einen Einstellungsparametersatz, verwendet werden.

In einem anderen Ansatz werden Protokolle so bestimmt, dass sie nur ein einziges Mal durchgeführt werden können ("run once", RO). Derartig bestimmte Protokollparametersätze nutzen mithin die Leistungsfähigkeit der Magnetresonanzeinrichtung soweit aus, dass sich die Zustandsparameter bis zur Betriebsgrenze hin verändern dürfen. Damit einher geht die Notwendigkeit, den Anfangssystemzustand der Magnetresonanzeinrichtung in die Modellierung mit einzubeziehen.

Ist die Magnetresonanzeinrichtung beispielsweise schon aufgeheizt, kann keine Messung mehr durchgeführt werden, die die Magnetresonanzeinrichtung beziehungsweise die konkret betroffenen Komponenten über die Betriebsgrenze hinaus aufheizen würde. Da sich die Magnetresonanzeinrichtung im Ruhezustand wieder abkühlt, kann für ein gegebenes RO-Protokoll ermittelt werden, ab wann es wieder durchgeführt werden kann. Die Verwendung von RO-Protokollen kann also durch die Einführung von Messpausen unterstützt werden, was aber den Messablauf unter Umständen signifikant beeinträchtigen kann. Daher wurden derartige Ansätze bislang nicht weiterverfolgt.

Bisher wurden die Werte der Protokollparameter, die die Magnetresonanzeinrichtung für eine Messung zulässt, so konservativ eingeschränkt, dass die Leistungsfähigkeit der Magnetresonanzeinrichtung im Allgemeinen nicht vollständig ausgenutzt werden kann. Insbesondere kann vorgesehen sein, dass lediglich Protokolle gemäß dem RORE-Ansatz eingesetzt werden. Dies führt zu einer suboptimalen Ausnutzung der verfügbaren Systemperformance, was insbesondere vor dem Hintergrund eines steigenden Kostendrucks für die verwendeten Hardware-Komponenten fragwürdig ist. Ferner wurden bereits Magnetresonanzeinrichtungen vorgeschlagen, die zu relativ hohen Spitzenleistungen in der Lage sind, jedoch damit einhergehend eine geringere nominale Dauerleistung bereitstellen können, was die erreichbare Magnetresonanzdatenqualität bei RORE-Protokollen weiter reduzieren beziehungsweise die Aufnahmezeit weiter verlängern kann, obwohl die Magnetresonanzeinrichtung grundsätzlich zu deutlich besseren Leistungen im Stande wäre.

Die nachveröffentlichte europäische Patentanmeldung EP 19152127.7 offenbart ein Verfahren zum Betrieb einer Magnetresonanzeinrichtung, bei dem ein benutzerseitig vorgebbarer Boost-Parameter genutzt wird, um gegenüber dem Konzept der beliebig häufigen, also unbegrenzten, Wiederholbarkeit eines Protokolls beziehungsweise Protokollabschnitts eine höhere Leistungsfähigkeit für eine bestimmte Messung verfügbar zu machen. Dort wird vorgeschlagen, von der strikten RORE-Anforderung an durchzuführende Protokolle abzuweichen und auf benutzerseitige Anforderung eine gewisse Aufheizung der Magnetresonanzeinrichtung zuzulassen. Abhängig von dem Boost-Parameter werden Anpassungsparameter bestimmt, die eine verbesserte Ausnutzung der Leistungsfähigkeit der Magnetresonanzeinrichtung erlauben. Diese können durch Simulation des Verhaltens des wenigstens einen Zustandsparameters, insbesondere durch Ausrollen des Protokollabschnitts und/oder unter Verwendung eines Zustandsparametermodells, ermittelt werden.

Hierdurch wird die Bedienung der Magnetresonanzeinrichtung jedoch wieder verkompliziert, insbesondere, da mögliche Einstellwerte für den Zustandsparameter erst vom Benutzer erlernt werden müssen.

Der Erfindung liegt daher die Aufgabe zugrunde, eine Möglichkeit anzugeben, Einstellungsparametersätze, die Vorgaben für Protokollparameter von Messprotokollen für eine Magnetresonanzeinrichtung enthalten, bereitzustellen, die zum einen eine verbesserte Ausnutzung der Leistungsfähigkeit der Magnetresonanzeinrichtung erlauben, zum anderen aber eine wenig komplizierte Bedienung der Magnetresonanzeinrichtung bereitstellen.

Diese Aufgabe wird im Rahmen der vorliegenden Erfindung gelöst durch die Verfahren, die Bereitstellungseinrichtung, die Magnetresonanzeinrichtung und die Computerprogramme gemäß den unabhängigen Ansprüchen. Vorteilhafte Ausgestaltungen ergeben sich aus den Unteransprüchen.

Bei einem Verfahren der eingangs genannten Art ist erfindungsgemäß vorgesehen, dass je ein Einstellungsparametersatz für wenigstens zwei Temperaturzustandsklassen der Magnetresonanzeinrichtung unter Verwendung eines die Entwicklung des Temperaturzustands wenigstens einer Komponente der Magnetresonanzeinrichtung, die bei der Ausführung des Messprotokolls erwärmt wird, während der Ausführung des Messprotokolls beschreibenden Temperaturmodells derart ermittelt wird, dass für jeden Starttemperaturzustand, der in der Temperaturzustandsklasse enthalten ist, zu Beginn einer Messung mit einem Messprotokoll, das Protokollparameter gemäß den Vorgaben des Einstellungsparameterdatensatzes nutzt, eine Überhitzung, beschrieben durch Überschreitung einer Grenztemperatur, der wenigstens einen Komponente durch die maximal für eine vorgegebene Wiederholungsanzahl wiederholte Messung mit dem Messprotokoll vermieden wird.

Ein Messprotokoll dient der Aufnahme von Magnetresonanzdaten mit einer Magnetresonanzeinrichtung, hier insbesondere einer Magnetresonanzeinrichtung eines bestimmten Typs beziehungsweise Modells. Ein Messprotokoll umfasst üblicherweise wenigstens eine Magnetresonanzsequenz, sodass die Protokollparameter, die das Messprotokoll beschreiben, auch die Sequenzparameter der wenigstens einen Magnetresonanzsequenz umfassen. Je nach konkreter Ausgestaltung können Protokollparameter eines Messprotokolls an der Magnetresonanzeinrichtung fest vorgegeben sein, denkbar ist es zusätzlich oder alternativ jedoch auch, dass ein Benutzer die Protokollparameter für seine Bedürfnisse anpassen kann, insbesondere innerhalb eines bestimmten Einstellungsbereichs. So sind beispielsweise im Stand der Technik Messprotokolle bekannt, bei denen die Repetitionszeiten (TR), Echozeiten (TE) und dergleichen grundsätzlich anpassbar sind, wofür ein bestimmter Einstellungsbereich vorgegeben sein kann. Wählt ein Benutzer an der Magnetresonanzeinrichtung ein bestimmtes Messprotokoll an, werden die zu verwendenden Werte der Protokollparameter beziehungsweise Startwerte bei einer Einstellbarkeit genau wie gegebenenfalls benötigte Einstellbereiche an der Magnetresonanzeinrichtung üblicherweise durch Einstellungsparametersätze beziehungsweise konkret deren Einstellungsparameter gegeben, die mithin eine Vorgabe für die Protokollparameter beziehungsweise deren Wertebereiche vorgeben. Die vorliegende Erfindung befasst sich mit der Bereitstellung solcher Einstellungsparametersätze für eine, insbesondere bestimmte, Magnetresonanzeinrichtung, wobei diese Einstellungsparametersätze üblicherweise bereits werkseitig, also vor der ersten Inbetriebnahme der Magnetresonanzeinrichtung, vorbestimmt und sozusagen mit der Magnetresonanzeinrichtung "mitgeliefert" werden.

Dabei kann es im Rahmen der vorliegenden Erfindung zweckmäßig und auch in Ausführungsbeispielen vorgesehen sein, dass Einstellungsparametersätze für mehrere unterschiedliche Messprotokolle ermittelt werden. Beispielsweise kann einem Benutzer in einem konkreten Fall nach Auslieferung der Magnetresonanzeinrichtung eine Auswahl zwischen unterschiedlichen Messprotokollen für unterschiedliche klinische Fragestellungen bereitgestellt werden, nach deren Auswahl Werte für die Protokollparameter vorgegeben werden und gegebenenfalls innerhalb bestimmter Einstellbereiche anpassbar sind.

Dabei bezieht sich die vorliegende Erfindung insbesondere auf solche Protokollparameter, deren Verwendung Einfluss auf den Temperaturzustand der Magnetresonanzeinrichtung, insbesondere also die Temperatur wenigstens einer Komponente der Magnetresonanzeinrichtung, hat. Bei einer derartigen Komponente kann es sich beispielsweise um einen Gradientenverstärker, eine Gradientenspulenanordnung selber, einen Hochleistungsverstärker und/oder Kabel handeln. Beispielsweise kann die Verwendung von Gradientenpulsen, insbesondere Gradientenpulsen höherer Amplitude, zu einer Erwärmung einer solchen Komponente führen, welche aber wiederum eine durch eine Grenztemperatur beschriebene Betriebsgrenze nicht überschreiten soll, mithin nicht überhitzt werden soll. Um dies abzuschätzen, wird ein Temperaturmodell verwendet, über welches beispielsweise prognostiziert werden kann, welche Erhitzung bei bestimmten Protokollparametern, die auch den Zeitablauf des Messprotokolls beziehungsweise wenigstens einer verwendeten Magnetresonanzsequenz betreffen können, zu erwarten ist und dergleichen. Protokollparameter, die den Temperaturzustand der Magnetresonanzeinrichtung betreffen, können beispielsweise Gradientenpulse oder aber allgemein den zeitlichen Abstand beschreiben, nachdem beispielsweise bei längeren Repetitionszeiten längere Abkühlzeiträume vorliegen. Auch Pausenzeiträume können von Protokollparametern beschrieben werden. Das Temperaturmodell wird nun genutzt, um abzuschätzen, welche Protokollparameter denkbar sind, um eine Überhitzung der wenigstens einen Komponente zu vermeiden, wobei dabei selbstverständlich auch mehrere Komponenten betrachtet werden können, oder aber die kritischste Komponente, wenn diese zumindest im Wesentlichen immer als erste überhitzen würde. Die sich entsprechenden Werte beziehungsweise Spielräume für Protokollparameter, mithin Vorgabewerte und vorgegebene Wertebereiche, bilden einen Einstellungsparametersatz.

Dabei wurde im Rahmen der vorliegenden Erfindung erkannt, dass der Starttemperaturzustand der Magnetresonanzeinrichtung eine wesentliche Rolle für die Fragestellung der Überhitzung bildet. Ist beispielsweise eine Komponente zu Beginn eines Messprotokolls schon sehr heiß, liegt ihre Temperatur beispielsweise also nahe an der Grenztemperatur, besteht ein deutlich höheres Risiko für eine Überhitzung und somit ein deutlich geringerer Spielraum für Protokollparameter beziehungsweise Kombinationen von deren Werten, die gefahrlos eingesetzt werden können. Die vorliegende Erfindung schlägt nun vor, mögliche zu Beginn des Messprotokolls vorliegende Temperaturzustände in Temperaturzustandsklassen zu klassifizieren, um für mehrere solcher Temperaturzustandsklassen Einstellungsparametersätze bereitzustellen.

Dieses Bereitstellen mehrerer Einstellungsparametersätze für ein Messprotokoll, die jeweils für eine andere Temperaturzustandsklasse geeignet sind, bringt hinsichtlich der Bedienungsfreundlichkeit der Magnetresonanzeinrichtung deutliche Vorteile mit sich, da eine automatische Auswahl, die eine Überhitzung vermeiden sollte, weiterhin möglich ist, jedoch dennoch anhand der Temperaturzustandsklassen eine verbesserte Ausnutzung der Leistungsfähigkeit der Magnetresonanzeinrichtung ermöglicht werden kann. Beispielsweise kann, worauf im Folgenden noch genauer eingegangen werden wird, gemäß der üblichen Benutzung der Magnetresonanzeinrichtung, insbesondere deren Einsatzklasse, und/oder aufgrund eines tatsächlich vorliegenden Starttemperaturzustands der Magnetresonanzeinrichtung ein Einstellungsparametersatz gewählt werden.

Die Einstellungsparameter der Einstellungsparametersätze werden dabei so ermittelt, dass für jeden Starttemperaturzustand, der in der entsprechenden Temperaturzustandsklasse enthalten ist, bei Nutzung eines Messprotokolls gemäß Vorgabe durch den Einstellungsparametersatz eine Überhitzung der wenigstens einen Komponente vermieden wird. Mit anderen Worten wird nicht länger davon ausgegangen, dass der Einstellungsparametersatz so bestimmt werden muss, dass für alle denkbaren Starttemperaturzustände der Magnetresonanzeinrichtung die Überhitzung vermieden wird, sondern es wird nach Temperaturzustandsklassen unterschieden, mithin nicht länger konservativ vom "Worst Case" ausgegangen. Mit anderen Worten wird ein vordefinierter Temperaturzustand der Magnetresonanzeinrichtung vorausgesetzt und für diese Gegebenheiten werden die Protokollparameter optimiert, sodass sich entsprechende Vorgaben in Form der Einstellungsparameter ergeben. Die Wahl dieser vordefinierten Temperaturzustandsklassen kann eine auf verschiedenen Wegen ermittelte Abschätzung darstellen, die angibt, wie warm die Magnetresonanzeinrichtung typischerweise und/oder im "Worst Case"-Fall zu Beginn der relevanten Messung mit dem Messprotokoll höchstwahrscheinlich ist. Entsprechend stellt dieses Vorgehen im Gegensatz zur Vorgabe eines Boost-Parameters eine vollautomatische Optimierung des Messablaufs dar und bietet den Vorteil, dass dem Nutzer eine valide Abschätzung gegeben werden kann, mit welchen Protokollparametern eine Messung höchstwahrscheinlich ausführbar sein wird.

Abhängig von angenommenen oder tatsächlichen Anfangsbedingungen, also Starttemperaturzuständen, an der Magnetresonanzeinrichtung, für die die Einstellungsparametersätze bereitgestellt werden sollen, kann beispielsweise auch der einstellbare Wertebereich, beispielsweise für TE und TR, variieren. Bei "idealen" Startzuständen kann so mittels des der entsprechenden Temperaturzustandsklasse zugeordneten Einstellungsparametersatzes ein größerer Wertebereich zur Einstellung zur Verfügung stehen, beispielsweise kleinere Repetitionszeiten einstellbar sein, als bei "typischen" Starttemperaturzuständen. Bei "Worst Case"-Starttemperaturzuständen kann beispielsweise der kleinstmögliche Wertebereich zur Einstellung zur Verfügung stehen, sodass beispielsweise eine Dreifachunterteilung möglich ist. Was Einstellungsparameter, die unmittelbar Werte für Protokollparameter wiedergeben, angeht, kann selbstverständlich eine analoge Betrachtung durchgeführt werden, sodass beispielsweise die kürzesten Repetitionszeiten bei idealen thermischen Anfangsbedingungen, mithin einer entsprechenden Temperaturzustandsklasse, hin zu höheren Repetitionszeiten bei schlechteren Anfangsbedingungen wiedergebenden Temperaturzustandsklassen vorliegen.

Mit anderen Worten wird für die Vordefinition von sinnvollen Parametrisierungen, beschrieben durch die Einstellungsparametersätze, von Messprotokollen vorgeschlagen, dass von typischen Starttemperaturzuständen ausgegangen wird, die in einem typischen beziehungsweise realistischen Einsatz zu erwarten sind. Dieses Vorgehen ist besonders vorteilhaft, um den Benutzer schon vor der Ausführung beziehungsweise vor dem Start eines Messprotokolls mit wenigstens einer Magnetresonanzsequenz eine valide Abschätzung zur Verfügung zu stellen, mit welchen Protokollparametern das betreffende Messprotokoll höchstwahrscheinlich lauffähig ist. Auf diese Weise lassen sich beispielsweise optimierte Abfolgen von Magnetresonanzmessungen, jeweils beschrieben durch ein Messprotokoll, vordefinieren, bei denen sich optimierte Messungen mit hoher und solche mit geringer Gradientenlast abwechseln.

Dabei sei an dieser Stelle noch angemerkt, dass die Verwendung eines Temperaturmodells im Gegensatz zu Probemessungen an einer bestimmten Magnetresonanzeinrichtung mehrere Vorteile hat. Zum einen werden durch die Modellierung bestimmte Toleranzen abgedeckt, die in speziell verwendbaren Messphantomen fehlen würden. Zum anderen kann es auch zwischen Magnetresonanzeinrichtungen eines Typs beziehungsweise eines Modells gewisse Abweichungen geben, die Auswirkungen auf Einstellungsparametersätze haben können. Ein Temperaturmodell lässt sich auf eine bestimmte Magnetresonanzeinrichtung jedoch vorteilhaft kalibrieren, sodass die Einzelexemplarschwankung reduziert wird. Hierauf wird im Folgenden noch genauer eingegangen werden.

Im Rahmen der vorliegenden Erfindung kann von einer oder mehreren konkreten Wiederholungsanzahlen ausgegangen werden. Während die Wiederholungsanzahl grundsätzlich auch Null betragen kann (RO-Fall), hat es sich im Rahmen der vorliegenden Erfindung als besonders vorteilhaft erwiesen, als Wiederholungsanzahl Eins zu wählen. Es kann im Rahmen der vorliegenden Erfindung, allgemein gesagt, eine feste Wiederholungsanzahl, wie oft ein Messprotokoll wiederholbar sein soll, verwendet werden, wobei besonders bevorzugt festgelegt wird, dass genau eine Wiederholung möglich sein muss. Diese Auswahl ist, basierend auf typischen, bekannten Arbeitsabläufen, eine sinnvolle Wahl, die die meisten Fälle abdeckt. Dabei ist es selbstverständlich denkbar, wenn Einstellungsparametersätze für mehrere Messprotokolle ermittelt werden, die Wiederholungsanzahl auch messprotokollspezifisch vorzugeben. Während theoretisch auch eine Vorgabe einer unendlich häufigen Wiederholbarkeit (RORE-Fall) denkbar ist, ist dies im Rahmen der vorliegenden Erfindung jedoch weniger bevorzugt, da dieser Fall nicht unbedingt der Praxis entspricht und eine zu konservative Annahme darstellt.

Denkbar ist es im Rahmen der vorliegenden Erfindung jedoch auch, Einstellungsparametersätze für unterschiedliche Wiederholungsanzahlen zu bestimmen. Beispielsweise ist es möglich, als eine Art Rückfallmöglichkeit einen RORE-Einstellungsparametersatz für eine die höchsten Temperaturzustände enthaltende Temperaturzustandsklasse zu ermitteln und an den Magnetresonanzeinrichtungen ebenso bereit zu stellen, wenn andere Protokollparametervorgaben nicht mehr sinnvoll möglich sind.

Im Rahmen der vorliegenden Erfindung kann auch vorgesehen sein, dass der Einstellungsparametersatz bei mehreren enthaltenen Einstellungsbereichen Abhängigkeiten zwischen wenigstens einem Teil dieser Einstellungsbereiche enthaltend ermittelt wird. In der Magnetresonanz ist es häufig so, dass die Temperatur der wenigstens einen Komponente beeinflussende Protokollparameter voneinander abhängige Wertebereiche beziehungsweise Einstellungen aufweisen kann. Wird beispielsweise eine niedrigere maximale Gradientenstärke für Gradientenpulse gewählt, sind kürzere Repetitionszeiten denkbar als bei höheren maximalen Gradientenstärken. Entsprechend können die Wertebereiche so in dem Einstellungsparametersatz vorgegeben sein, dass sich je nach Einstellung eines Protokollparameters der anwählbare Wertebereich für einen anderen Protokollparameter verändern kann. Derartige Abhängigkeiten können auch als mathematische Zusammenhänge in dem Einstellungsparametersatz hinterlegt sein.

In besonders vorteilhafter Weiterbildung der vorliegenden Erfindung können die Temperaturzustandsklassen durch Auswertung von bei Nutzung einer zumindest im Wesentlichen baugleichen Magnetresonanzeinrichtung ermittelte Starttemperaturzustände für das Messprotokoll beschreibenden Vorgabeinformationen definiert werden. Dabei ist es beispielsweise denkbar, bei bereits in Betrieb befindlichen Magnetresonanzeinrichtungen desselben Typs beziehungsweise Modells, also baugleichen Magnetresonanzeinrichtungen, gemessene oder anderweitig ermittelte Starttemperaturzustände zu Beginn des Messprotokolls, für das Einstellungsparametersätze ermittelt werden sollen, festzustellen. Dabei kann beispielsweise vorgesehen sein, dass bei der üblichen Datenaufnahme und Betriebsüberwachung von Magnetresonanzeinrichtungen solche Vorgabeinformationen ohnehin aufgenommen und mitprotokolliert werden. Dabei ist es im Stand der Technik bereit bekannt, beispielsweise seitens des Herstellers der Magnetresonanzeinrichtungen derartige Betriebsinformationen zu sammeln und entsprechend auszuwerten, in welchem Rahmen auch die Vorgabeinformation zusammengestellt werden können und/oder die Temperaturzustandsklassen definiert werden können.

Mit besonderem Vorteil kann dabei vorgesehen sein, dass die Vorgabeinformation nach wenigstens einer Einsatzklasse aufgeschlüsselt vorliegt, wobei die Auswertung und/oder die Definition der Temperaturzustandsklassen in Abhängigkeit der Einsatzklassen erfolgt. Eine Einsatzklasse ist im Rahmen der vorliegenden Erfindung so zu verstehen, dass der Einsatzbereich der Magnetresonanzeinrichtung, also ihre Betriebsumstände nach der Inbetriebnahme, abgebildet werden. Beispielsweise sind neben Magnetresonanzeinrichtungen, die im klinischen Gebrauch ständig voll ausgelastet sind und viele anspruchsvolle Messprotokolle, auch bezüglich der Temperatur, nutzen können, auch Magnetresonanzeinrichtungen in Einsatzgebieten bekannt, in denen eine deutlich niedrigere Auslastung vorliegt, beispielsweise längere Pausen zwischen einzelnen Untersuchungsvorgängen existieren, und/oder weniger aufwändige beziehungsweise komplexe Messprotokolle eingesetzt werden. Schließlich sind auch Magnetresonanzeinrichtungen bekannt, die im Hochbelastungsbetrieb, beispielsweise für Forschungszwecke oder dergleichen, betrieben werden. Mithin ist es beispielhaft denkbar, eine Einsatzklasse für "sporadische Nutzung", eine Einsatzklasse für "typische Nutzung" und eine Einsatzklasse für "starke Nutzung" zu definieren und die Vorgabeinformationen entsprechend zu sortieren, nachdem beispielsweise bei für Forschungszwecke stark ausgelasteten und anspruchsvolle Messprotokolle nutzenden Magnetresonanzeinrichtungen häufig höhere Temperaturen vorliegen als beispielsweise bei typisch oder nur sporadisch genutzten Magnetresonanzeinrichtungen. Entsprechend ist es auch möglich, beispielsweise für jede Einsatzklasse eine entsprechende Temperaturzustandsklasse zu definieren, beispielsweise derart, dass ein Großteil der in den Vorgabeinformationen erfassten Starttemperaturzustände umfasst sind und zusätzlich noch eine Ausnahmefallklasse definiert werden kann. So ist es insbesondere möglich, für bestimmte Magnetresonanzeinrichtungen, für die die zukünftige Einsatzklasse bekannt ist, unmittelbar geeignete Einstellungsparametersätze bereitzustellen.

Zweckmäßigerweise kann wenigstens ein Teil der Temperaturzustandsklassen derart bestimmt sein, dass ein vorgegebener, Starttemperaturzustände mit den höchsten Temperaturen ausschließender Anteil der insbesondere einsatzklassenspezifisch betrachteten Starttemperaturzustände der Vorgabeinformation enthalten ist. Beispielsweise kann ein standardmäßig, insbesondere bei einer Einsatzklasse, zu nutzender Einstellungsparametersatz für eine Starttemperaturklasse ermittelt werden, die 80 bis 95 %, beispielsweise 90 %, der gemäß Vorgabeinformationen zu erwartenden Starttemperaturzustände abdeckt.

Zusätzlich und/oder alternativ sieht eine allgemein einsetzbare Ausführungsform der vorliegenden Erfindung vor, dass wenigstens ein Teil der Temperaturzustandsklassen durch Schwellwerte für die Temperatur der wenigstens einen Komponente definiert wird, wobei insbesondere die Schwellwerte wenigstens teilweise abhängig von einer Kühltemperatur, auf die die Komponente mittels einer dieser zugeordneten Kühleinrichtung gekühlt wird, und/oder der Grenztemperatur gewählt werden. So kann beispielsweise vorgesehen sein, eine Temperaturzustandsklasse für ideale Anfangsbedingungen derart zu definieren, dass sich die Komponente auf der Kühltemperatur oder zumindest nur in einem Intervall darüber befindet, während typische Anfangsbedingungen in einer Starttemperaturklasse beispielsweise den ideale Anfangsbedingungen ausnehmenden Temperaturbereich bis hin zu der Kühltemperatur plus die Hälfte der Differenz zwischen der Grenztemperatur und der Kühltemperatur beträgt. Schließlich können "worst case"-Anfangsbedingungen durch die restlichen Fälle abgedeckt werden, in denen sich die Komponente auf oder nahe der Grenztemperatur befindet. Selbstverständlich sind auch andere Möglichkeiten zur Definition geeigneter Temperaturzustandsklassen mittels der Kühltemperatur und/oder der Grenztemperatur möglich.

Denkbar ist es im Allgemeinen ferner auch, dass wenigstens ein Teil der Temperaturzustandsklassen in Abhängigkeit von einem Betrieb der Magnetresonanzeinrichtung in einem unmittelbar zu Beginn des Messprotokolls endenden Zeitabschnitt definiert sind. Beispielsweise definiert eine Benutzungspause vor Beginn des Messprotokolls, inwieweit die Magnetresonanzeinrichtung von der vorherigen Benutzung abgekühlt ist und dergleichen. So ist es beispielsweise möglich, eine Temperaturzustandsklasse für ideale Anfangsbedingungen derart zu definieren, dass die Magnetresonanzeinrichtung wenigstens fünf Minuten Zeit zur Abkühlung hatte, beispielsweise durch einen Patientenwechsel und/oder eine Localizer-Messung. "Worst Case"-Anfangsbedingungen können beispielsweise derart definiert werden, dass die Magnetresonanzeinrichtung zuvor über wenigstens eine bestimmte Zeitdauer mit nicht-RORE-Messprotokollen betrieben wurde, die für eine Aufheizung sorgen.

Im Folgenden sollen einige Beispiele zusammengefasst werden, wie Temperaturzustandsklassen für "ideale Anfangsbedingungen", "typische Anfangsbedingungen" und "Worst Case-Anfangsbedingen" definiert werden können, wobei diese rein beispielhaft zu verstehen sind und nicht als den Gegenstand der vorliegenden Erfindung einschränken.

So können beispielsweise "ideale Anfangsbedingungen" angenommen werden können, wenn

- sich die wenigstens eine Komponente auf der Kühltemperatur befindet oder
- die Magnetresonanzeinrichtung wenigstens fünf Minuten Zeit zur Abkühlung hatte oder
- sich die Magnetresonanzeinrichtung in einem Temperaturzustandsbereich befindet, in dem statistisch beispielsweise 10 % der klinischen Messungen, insbesondere auf die Einsatzklasse bezogen, starten.

Eine Temperaturzustandsklasse für "typische Anfangsbedingungen" kann beispielsweise dadurch definiert werden, dass

- sich die wenigstens eine Komponente maximal auf der Summe der Kühltemperatur und des halben Abstands zwischen Grenztemperatur und Kühltemperatur befindet oder
- die Magnetresonanzeinrichtung zuvor wenigstens 30 Minuten mit RORE-Messprotokollen betrieben wurde, falls diese zur Einhaltung eines Abstands von der Grenztemperatur ausgelegt sind, oder
- sich die Magnetresonanzeinrichtung innerhalb eines Temperaturzustandsbereichs befindet, in dem statistisch 80 % der klinischen Messungen starten, wobei die höchsten Temperaturzustände ausgeschlossen sind.

Eine Temperaturklasse mit "Worst Case"-Anfangsbedingungen kann dadurch definiert werden, dass sich beispielsweise

- die wenigstens eine Komponente auf oder nahe der Grenztemperatur befindet oder
- die Magnetresonanzeinrichtung zuvor über mehrere Minuten mit Messprotokollen betrieben wurde, bei denen eine vorbestimmte Grenze überschreitenden mittlere Gradientenstärke verwendet wird.

In einer bevorzugten Ausgestaltung der vorliegenden Erfindung kann ein lineares Temperaturmodell verwendet werden, bei dem in einer Differentialgleichung ein linearer Zusammenhang zwischen der Temperatur und ihrer zeitlichen Ableitung über eine Zeitkonstante angenommen wird und eine den Leistungseintrag berücksichtigende Energiebilanz gebildet wird. Als Lösung der Differentialgleichung kann ein exponentieller Zusammenhang angenommen werden.

Über ein solches Temperaturmodell ist es also insbesondere möglich, das Erwärmungsverhalten der wenigstens einen Komponente zu modellieren, um die bestehenden Limitierungen optimal ausnutzen zu können. Aus einem derartigen Temperaturmodell können verschiedene Vorhersagen erstellt werden, beispielsweise die mögliche Leistung, die unter gewissen Randbedingungen, beispielsweise abhängig von der Starttemperatur der Komponente und/oder der Kühltemperatur der Komponente, über einen definierten Zeitraum appliziert werden kann, bevor die thermische Limitierung der wenigstens einen Komponente, mithin die Grenztemperatur, erreicht ist. Dabei ist zu betonen, dass die applizierbare mögliche Leistung auch von der prognostizierten Messdauer, beispielsweise Sequenzdauer, abhängen kann.

Ferner kann über ein derartiges Temperaturmodell eine Vorhersage der Zeitdauer während der Applizierung einer bestimmten Leistung ermöglicht werden, bis die wenigstens eine Komponente eine gewisse Temperaturerwärmung erreicht, z. B. die Grenztemperatur der wenigstens einen Komponente. Dies erlaubt beispielsweise die Vorhersage, wie oft eine gewisse Magnetresonanzsequenz beziehungsweise ein bestimmtes Messprotokoll wiederholt werden kann, bevor eine thermische Limitierung erreicht ist.

Schließlich kann auch die Temperatur vorhergesagt werden, die eine Komponente zu einem bestimmten Zeitpunkt, beispielsweise zum Start des Messprotokolls nicht überschreiten darf, damit während einer gewissen Zeit eine gewisse Leistung appliziert werden kann, die zu einer definierten Temperatur der wenigstens einen Komponente führt. Dies erlaubt beispielsweise die Vorhersage, wie lange gewartet werden muss, bis die wenigstens eine Komponente soweit abgekühlt ist, dass ein bestimmtes Messprotokoll mit definierten Protokollparametern ausgeführt werden kann, ohne dass in dem Messprotokoll beispielsweise Kühlpausen eingefügt werden müssen. Für bestimmte Untersuchungen kann dies sinnvoll sein, wenn beispielsweise die Einfügung von Kühlpausen zu Einbußen der Bildqualität führen kann.

Für die Bereitstellung von Einstellungsparametersätzen wird, wie bereits angedeutet wurde, besonders bevorzugt ein lineares Temperaturmodell herangezogen, welches durch die Differentialgleichung

$$\dot{T} = P - \frac{1}{\tau}(T - Tcool) \qquad\qquad (3)$$

Beschrieben werden kann. Darin bezeichnet T die Temperatur, $\dot{T}$ deren zeitliche Änderung (mithin die erste Ableitung nach der Zeit) und P die applizierte thermische Leistung, $\tau$ die thermische Zeitkonstante und Tcool die Kühltemperatur, mit der die betreffende Komponente über einen geeigneten Mechanismus, konkret eine Kühleinrichtung, gekühlt wird. Beispielsweise kann die Kühltemperatur eine Temperatur eines verwendeten Kühlwassers sein. Eine Lösung dieser Differentialgleichung kann formuliert werden als

$$T = (\tau P + Tcool - T0)\left(1 - e^{-\frac{t}{\tau}}\right) + T0 \quad , \qquad\qquad (4)$$

wobei T0 die Starttemperatur bezeichnet. Daraus ergibt sich beispielsweise für die Temperatur einer Komponente, deren Starttemperatur der Kühltemperatur entspricht und die eine konstante thermische Belastung erfährt, dass die Temperatur zunächst exponentiell anwächst und schließlich in einer Sättigungstemperatur endet. Zum Schutz der hier relevanten wenigstens einen Komponente wird davon ausgegangen, dass deren Temperatur eine Grenztemperatur nicht überschreiten darf. Im Kontext von Magnetresonanzsequenzen ist also darauf zu achten, dass die Sequenzparameter als spezielle Protokollparameter entsprechend limitiert werden. Dies kann beispielsweise bedeuten, dass die ausgespielten Gradientenpulse in gewisser Weise eingeschränkt werden müssen und/oder dass im Laufe der wenigstens einen Magnetresonanzsequenz eines Messprotokolls Pausen eingefügt werden müssen, während derer eine Abkühlung der wenigstens einen Komponente erfolgen kann.

Dabei sieht eine zweckmäßige Weiterbildung der vorliegenden Erfindung vor, dass die Zeitkonstante größer als eine Minute ist, wobei insbesondere der Leistungseintrag als proportional zu einer mittleren Gradientenleistung, insbesondere einer mittleren quadratischen Gradientenstärke, angenommen wird.

Im Kontext der vorliegenden Erfindung sind Komponenten von Interesse, die bezüglich ihrer Erwärmung eine thermische Zeitkonstante $\tau$ aufweisen, die deutlich größer als die Zeitstruktur ist, mit der die jeweilige Komponente thermisch belastet wird. Dann ergibt sich die Möglichkeit, die Berechnung der Temperatureffekte durch thermische Belastungen dahingehend zu vereinfachen, dass die jeweilige thermische Belastung über einen gewissen Zeitbereich gemittelt wird. Derartige Komponenten können, wie eingangs erwähnt, beispielsweise eine Gradientenspulenanordnung, ein Gradientenverstärker, ein Kabel oder dergleichen sein.

Bei typischen Magnetresonanzsequenzen, in denen Gradientenpulse appliziert werden, weisen diese üblicherweise Zeitdauern im Bereich von ca. 100 μs bis 100 ms auf. Die Zeitdauer zwischen sich ganz oder teilweise wiederholenden Gradientenschemata liegen üblicherweise im Bereich von einigen Millisekunden bis einige Sekunden. Die Gradientenpulse stellen eine thermische Belastung dar, da für ihre Erzeugung in den oben beispielhaft erwähnten Komponenten Ströme fließen, die durch ohmsche Verluste thermische Leistung erzeugen. Betrachtet werden hier also Komponenten, deren thermische Zeitkonstante deutlich länger als diese Zeitstruktur der Magnetresonanzsequenzen ist, also insbesondere mehr als eine Minute, gegebenenfalls mehrere Minuten beträgt.

Dies ermöglicht es insbesondere, die thermische Leistung P als proportional zur mittleren quadratischen Gradientenstärke anzusehen, vgl. hierzu die eingangs dargelegte Gleichung (1). Dabei ist die Ermittlungszeit lang gegenüber der Zeitstruktur der Magnetresonanzsequenz anzusetzen, beispielsweise im Bereich der thermischen Zeitkonstante $\tau$. Es kann geschrieben werden:

$$P = \alpha\, Gms \quad . \tag{5}.$$

Dabei ist $\alpha$ eine Proportionalitätskonstante, die einen Modellparameter darstellt.

Wenigstens ein Modellparameter des Temperaturmodells, insbesondere die Zeitkonstante, kann in einer Kalibrierungsmessung mit der Magnetresonanzeinrichtung ermittelt werden, wobei insbesondere eine eine bekannte mittlere Gradientenleistung eintragende Magnetresonanzsequenz verwendet wird. Das bedeutet, es können Kalibrationsmessungen durchgeführt werden, um die Werte beispielsweise der Modellparameter $\alpha$, $\tau$ und Tcool zu bestimmen, wobei die Kühltemperatur Tcool auch als bekannt angesehen werden kann, da sie die Temperatur der Kühlung, beispielsweise des Kühlwassers, bezeichnet und somit unmittelbar ermittelt werden kann bzw. bekannt ist. Die Kalibrationsmessung kann beispielsweise mit einer standardisierten Magnetresonanzsequenz stattfinden, die eine bekannte mittlere quadratische Gradientenstärke Gms appliziert. Aus der Messung der Temperatur der wenigstens einen Komponente und durch einen Fit der Gleichung (4) an die in der Kalibrationsmessung ermittelten Kalibrierungsdaten können die Modellparameter bestimmt werden. Dabei wird bevorzugt jedes Exemplar eines Typs oder Modells von Magnetresonanzeinrichtungen, beispielsweise werkseitig, kalibriert, um der Exemplarstreuung Rechnung zu tragen und für jede Magnetresonanzeinrichtung die optimale Performance zu erhalten. Denkbar ist es jedoch auch, die Modellparameter durch Kalibrierung an einer geeigneten Stichprobe von baugleichen Magnetresonanzeinrichtungen zu ermitteln, wobei Extremwerte oder gemittelte Werte dieser Stichprobe verwendet werden, um durch eine gegebenenfalls konservative Abschätzung zumindest eine gleiche Performance für alle Magnetresonanzeinrichtungen dieses Typs beziehungsweise Modells zu ermöglichen.

Im Rahmen der vorliegenden Erfindung wird das insbesondere lineare Temperaturmodell für Vorhersagen angewendet, wobei verschiedene konkrete Wege zur Ermittlung von Einstellungsparametern als Vorgabe für Protokollparameter denkbar sind, die auch wenigstens teilweise kombiniert eingesetzt werden können. Dabei sind verschiedene Fragestellungen bei den Rechnungen denkbar, beispielsweise wie viel Leistung eingetragen werden kann, damit bei einer bestimmten Starttemperatur beziehungsweise allgemein bei einem bestimmten Starttemperaturzustand keine Überhitzung auftritt, wie lange eine bestimmte Leistung eingesetzt werden kann, bis die Grenztemperatur erreicht ist und dergleichen.

Am Beispiel der Formel (4) und (5) kann dies beispielsweise durch Umstellung

$$Gms = \frac{1}{\alpha\,\tau}\left(\frac{T - T0}{1 - e^{-\frac{t}{\tau}}} + T0 - Tcool\right) \tag{6}$$

erreicht werden. Mit der Formel (6) kann direkt vorhergesagt werden, welche mittlere quadratische Gradientenstärke für einen bestimmten Zeitraum t bei einer Starttemperatur T0 möglich ist, um eine Temperatur T zu erreichen beziehungsweise nicht zu überschreiten. Der Zeitraum t kann dabei beispielsweise die prognostizierte Laufzeit eines Messprotokolls beziehungsweise der wenigstens einen Magnetresonanzsequenz, die das Messprotokoll nutzt, sein. Die Gleichungen (1) und (2) können zur Bestimmung notwendiger Kühlpausen beziehungsweise zur Reduktion von Gradientenamplituden berücksichtigt werden. Wie jedoch bereits erwähnt, kann das hier verwendete Modell, insbesondere Gleichungen (4) und (5), jedoch auch für weitere Vorhersagen verwendet werden. Diese folgen ebenso aus einer direkten Umstellung der betreffenden Gleichungen.

Die Vorhersagen des Temperaturmodells können nun genutzt werden, um Vorgaben für die Protokollparameter eines Messprotokolls mit wenigstens einer Magnetresonanzsequenz in Form der Einstellungsparameter automatisch zu ermitteln und derart bereitzustellen, dass das Messprotokoll unter allen Bedingungen der entsprechenden Temperaturzustandsklasse lauffähig ist, ohne die thermischen Limitierungen der wenigstens einen Komponente zu überschreiten, wobei gleichzeitig eine Optimierung hinsichtlich der Messzeit und/oder der Bildqualität stattfinden kann.

Dies kann gegebenenfalls die iterative Anwendung eines Vorhersagevorgangs mit dem Temperaturmodell erfordern, so dass vorgesehen sein kann, dass die Ermittlung der Einstellungsparameter, insbesondere hinsichtlich der Einstellbereiche, in einem iterativen Verfahren erfolgt. Beispielsweise kann die Berechnung der maximal applizierbaren mittleren quadratischen Gradientenstärke Gms von einer ungefähren Laufzeit des Messprotokolls beziehungsweise von dessen wenigstens einer Magnetresonanzsequenz ausgehen. Je nach Ergebnis der Vorhersage kann sich nun beispielsweise herausstellen, dass das Messprotokoll hinsichtlich der in ihm eingefügten Pausen modifiziert werden muss. Dies würde eine neue prognostizierte Laufzeit des Messprotokolls ergeben, was eine neue Durchführung der Vorhersage erfordert. Mehrere Iterationen sind denkbar, wobei hier beispielsweise ein Konvergenzkriterium, z. B. ein maximal zulässiger Unterschied zwischen wiederholten Vorhersagen, angewendet werden kann, bis zu dem Iterationen stattfinden.

Es sei an dieser Stelle noch angemerkt, dass neben dem Einsatz zur Ermittlung von Einstellungsparametersätzen das hier beschriebene Temperaturmodell auch anderweitig eingesetzt werden kann, beispielsweise um aufgrund eines konkreten Starttemperaturzustands einer Magnetresonanzeinrichtung mit Hilfe des Temperaturmodells zu ermitteln, ob ein Messprotokoll mit bestimmten Protokollparametern ausführbar ist oder sogar Protokollparameter für ein Messprotokoll zu bestimmen. Ist bei einer solchen Anwendung beispielsweise die Ausführbarkeit eines Messprotokolls nicht gewährleistet, kann mit dem Temperaturmodell eine notwendige Wartezeit bestimmt werden oder eine notwendige Anpassung der Protokollparameter. Die Alternativen können dem Benutzer angezeigt werden, so dass er eine Auswahl treffen kann. Eine präferierte Alternative kann auch konfiguriert werden, so dass keine zusätzliche Benutzerinteraktion nötig ist.

Die Erfindung betrifft ferner auch ein Verfahren zum Betrieb einer Magnetresonanzeinrichtung zur Aufnahme von Magnetresonanzdaten mit einem durch Protokollparameter beschriebenen Messprotokoll, welches folgende Schritte aufweist:

- Bereitstellen von Einstellungsparametersätzen durch ein erfindungsgemäßes Bereitstellungsverfahren,
- Ermittlung von Protokollparametern für das Messprotokoll gemäß der Vorgabe eines für das Messprotokoll bereitgestellten Einstellungsparametersatzes, und
- Aufnahme der Magnetresonanzdaten unter Verwendung der ermittelten Protokollparameter.

Sämtliche Ausführungen zum erfindungsgemäßen Bereitstellungsverfahren lassen sich analog auf das erfindungsgemäße Betriebsverfahren anwenden.

Mit besonderem Vorteil kann bei dem erfindungsgemäßen Betriebsverfahren vorgesehen sein, dass der Einstellungsparametersatz in Abhängigkeit der Zugehörigkeit des Temperaturzustands zu Beginn des Messprotokolls zu einer Temperaturzustandsklasse und/oder der Zugehörigkeit der Magnetresonanzeinrichtung zu einer Einsatzklasse gewählt wird.

Es kann also vorgesehen sein, dass ein aktueller, tatsächlicher Starttemperaturzustand vor dem Start der Messung mit dem Messprotokoll ermittelt wird, wobei ein entsprechend passender Einstellungsparametersatz in Abhängigkeit der Zugehörigkeit dieses Starttemperaturzustands zu einer Temperaturzustandsklasse gewählt wird, nämlich als der der entsprechenden Temperaturzustandsklasse zugeordnete Einstellungsparametersatz. Die den aktuellen Temperaturzustand, beispielsweise die aktuelle Temperatur der wenigstens einen Komponente, beschreibenden Größen sollten aktuell ermittelt oder abgeschätzt werden. Vorteil der aktuellen Ermittlung, beispielsweise durch eine Messung, ist, dass Messungen für jedes einzelne Exemplar, also jede individuelle Magnetresonanzeinrichtung, optimiert werden. Der Vorteil einer Abschätzung ist, dass Messabläufe für alle Magnetresonanzeinrichtungen eines Typs beziehungsweise Modells identisch verlaufen. Dabei kann zur Prognostizierung einer Starttemperatur insbesondere auch das Temperaturmodell selbst eingesetzt werden.

Möglich ist es ferner auch, den Einstellungsparametersatz anhand einer Einsatzklasse der Magnetresonanzeinrichtung zu wählen, wobei besonders bevorzugt eine Ausgestaltung derart gewählt wird, dass beide Kriterien eingesetzt werden, insbesondere also für die Einsatzklasse einsatzklassenspezifisch Temperaturzustandsklassen definiert wurden, welche dann bei Magnetresonanzeinrichtungen der entsprechenden Einsatzklasse mit den Starttemperaturzustand der Magnetresonanzeinrichtung verglichen werden, um einen entsprechenden, bereitgestellten Einstellungsparametersatz auszuwählen.

Eine weitere Ausgestaltung des erfindungsgemäßen Betriebsverfahrens sieht vor, dass der tatsächliche, aktuelle Temperaturzustand vor dem Start der Messung mit dem Messprotokoll (Starttemperaturzustand) ermittelt wird, wobei dann, wenn der aktuelle Temperaturzustand nicht Teil der Temperaturzustandsklasse des genutzten Einstellungsparametersatzes ist, die ermittelten Protokollparameter durch Nutzung eines der Temperaturklasse, der der aktuelle Temperaturzustand angehört, zugehörigen Einstellungsparametersatzes und/oder durch Berechnung unter Benutzung des Temperaturmodells derart, dass eine Überhitzung der wenigstens einen Komponente vermieden wird, angepasst werden. Diese Ausgestaltung ist insbesondere dann zweckmäßig, wenn zwischen der Planung der Durchführung des Messprotokolls und dem eigentlichen Start des Messprotokoll noch eine gewisse Zeit vergeht, beispielsweise der Patient noch zu Ende vorbereitet werden muss und/oder weitere Messprotokolle vor dem hier relevanten Messprotokoll durchgeführt werden sollen. Wird dann, wenn das Messprotokoll tatsächlich starten soll, ein Starttemperaturzustand festgestellt, der außerhalb der Temperaturzustandsklasse liegt, deren Einstellungsparametersatz als Vorgabe für die Protokollparameter verwendet würde, kann im Rahmen der vorliegenden Erfindung noch reagiert werden, beispielsweise, indem der Einstellungsparametersatz der Temperaturzustandsklasse, der der Starttemperaturzustand angehört, zur Anpassung herangezogen wird oder gar das Temperaturmodell auch in diesem Fall genutzt wird, um Berechnungen anzustellen, die angepasste Protokollparameter derart bereitstellen, dass eine Überhitzung der wenigstens einen Komponente dennoch vermieden wird.

Wie bereits angedeutet wurde, kann das Temperaturmodell auch weitergehend bei der Magnetresonanzeinrichtung und deren tatsächlichen Betrieb eingesetzt werden, beispielsweise, indem bei einem benutzerdefinierten Messprotokoll, für das kein Einstellungsparametersatz bereitgestellt wurde, das Temperaturmodell zur Ermittlung von eine Überhitzung der wenigstens einen Komponente vermeidenden Protokollparametern verwendet wird.

Die Erfindung betrifft ferner eine Bereitstellungseinrichtung zur Durchführung eines erfindungsgemäßen Bereitstellungsverfahrens, aufweisend eine Klassendefinitionseinrichtung zur Definition der Temperaturzustandsklassen, eine Modellierungseinrichtung von Einstellungsparametersätzen und eine Schnittstelle zum Bereitstellen der Einstellungsparametersätze. Dabei kann die Bereitstellungseinrichtung konkret wenigstens einen Prozessor und wenigstens ein Speichermittel umfassen. Sämtliche Ausführungen bezüglich des erfindungsgemäßen Bereitstellungsverfahrens lassen sich analog auf die erfindungsgemäße Bereitstellungseinrichtung anwenden, mit welcher mithin ebenso die bereits genannten Vorteile erhalten werden können.

Eine erfindungsgemäße Magnetresonanzeinrichtung weist eine zur Durchführung eines erfindungsgemäßen Betriebsverfahrens ausgebildete Steuereinrichtung auf, welche ebenso insbesondere wenigstens einen Prozessor und wenigstens ein Speichermittel aufweisen kann. Die Steuereinrichtung kann eine Schnittstelle zur Kommunikation mit einer erfindungsgemäßen Bereitstellungseinrichtung aufweisen, insbesondere mit deren Schnittstelle zum Bereitstellen der Einstellungsparametersätze. Die Magnetresonanzeinrichtung kann ferner ebenso verschiedene Funktionseinheiten zur Durchführung von Schritten der erfindungsgemäßen Verfahren aufweisen.

Ein erfindungsgemäßes Computerprogramm ist beispielsweise direkt in einen Speicher einer Bereitstellungseinrichtung oder einer Steuereinrichtung einer Magnetresonanzeinrichtung ladbar und weist Programmmittel auf, um die Schritte eines hierin beschriebenen Verfahrens auszuführen, wenn das Computerprogramm in der Bereitstellungseinrichtung beziehungsweise der Steuereinrichtung der Magnetresonanzeinrichtung ausgeführt wird, wobei das Computerprogramm für eine Bereitstellungseinrichtung die Ausführung eines erfindungsgemäßen Bereitstellungsverfahrens bewirkt und das Computerprogramm für die Steuereinrichtung der Magnetresonanzeinrichtung das Ausführen eines erfindungsgemäßen Betriebsverfahrens bewirkt. Erfindungsgemäße Computerprogramme können auf elektronisch lesbaren Datenträgern gespeichert sein, wobei ein solcher elektronisch lesbarer Datenträger mithin darauf gespeicherte elektronisch lesbare Steuerinformationen umfasst, welche zumindest ein erfindungsgemäßes Computerprogramm umfassen und derart ausgestaltet sind, dass sie bei Verwendung des Datenträgers in einer Bereitstellungseinrichtung respektive einer Steuereinrichtung einer Magnetresonanzeinrichtung ein erfindungsgemäßes Bereitstellungsverfahren beziehungsweise Betriebsverfahren durchführen. Bei dem Datenträger kann es sich um einen nichttransienten Datenträger, beispielsweise eine CT-ROM, handeln.

Weitere Vorteile und Einzelheiten der vorliegenden Erfindung ergeben sich aus den im Folgenden beschriebenen Ausführungsbeispielen sowie anhand der Zeichnung. Dabei zeigen:

Fig. 1     einen Ablaufplan eines Ausführungsbeispiels eines erfindungsgemäßen Bereitstellungsverfahrens,

Fig. 2     einen Ablaufplan eines Ausführungsbeispiels eines erfindungsgemäßen Betriebsverfahrens,

Fig. 3     eine erfindungsgemäße Bereitstellungseinrichtung,

Fig. 4     eine erfindungsgemäße Magnetresonanzeinrichtung, und

Fig. 5     die funktionale Struktur einer Steuereinrichtung der Magnetresonanzeinrichtung gemäß Fig. 4.

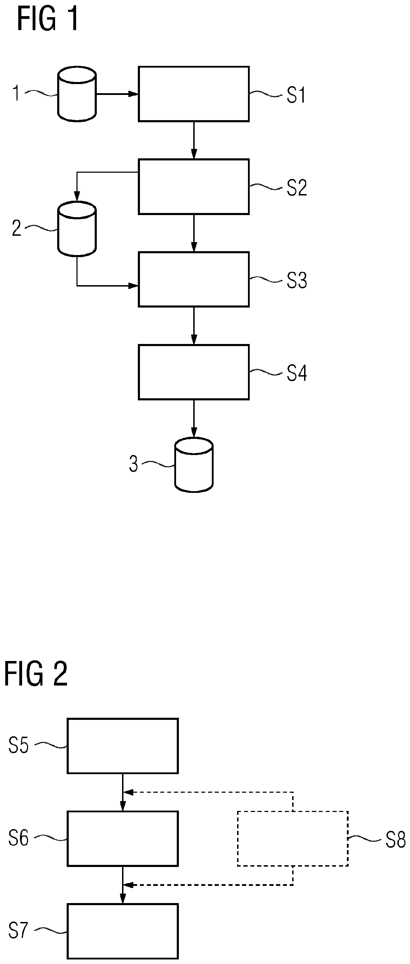

Fig. 1 zeigt einen Ablaufplan eines Ausführungsbeispiels eines erfindungsgemäßen Bereitstellungsverfahrens, mit dem Einstellungsparametersätze für unterschiedliche Messprotokolle einer Magnetresonanzeinrichtung, die einem bestimmten Typ/Modell beziehungsweise einer bestimmten Klasse von Magnetresonanzeinrichtungen zugehörig ist, ermittelt und bereitgestellt werden können. Messprotokolle werden dabei durch Protokollparameter beschrieben, die, nachdem Messprotokolle üblicherweise wenigstens eine Magnetresonanzsequenz umfassen, auch Sequenzparameter dieser wenigstens einen Magnetresonanzsequenz umfassen. Einstellungsparameter enthalten Vorgaben für die Protokollparameter, beispielsweise also vorgegebene Werte für bestimmte Protokollparameter und/oder vorgegebene, zulässige Wertebereiche, innerhalb denen beispielsweise seitens eines Benutzers der Wert des Protokollparameters gewählt werden kann. Vorliegend sind die in den Einstellungsparametersätzen niedergelegten Vorgaben wenigstens so, dass eine Überhitzung wenigstens einer bestimmten Komponente der Magnetresonanzeinrichtung, die bei Messbetrieb mit dem Messprotokoll erwärmt wird, vermieden wird. Die wenigstens eine Komponente kann dabei beispielsweise eine Gradientenspulenanordnung, einen Gradientenverstärker, Kabel oder dergleichen umfassen. Hierbei tritt die Erwärmung der wenigstens einen Komponente mithin insbesondere durch Gradientenpulse der wenigstens einen Magnetresonanzsequenz auf. Relevant sind hinsichtlich einer möglichen Überhitzung der wenigstens einen Komponente, insbesondere also hinsichtlich des Vermeidens der Überschreitung einer Grenztemperatur für die Komponente, auch den zeitlichen Ablauf des Messprotokolls bestimmende Protokollparameter, beispielsweise Repetitionszeiten, Echozeiten und dergleichen, da diese letztlich bestimmen, inwieweit Abkühlzeiträume vorliegen. Entsprechend können auch solchen Protokollparametern entsprechende Einstellungsparameter des Einstellungsparametersatzes zugeordnet sein. Im Allgemeinen werden dabei bei Einsatz erfindungsgemäßer Verfahren Einstellungsparametersätze bereitgestellt, deren Vorgaben nicht nur auf eine Vermeidung einer Überhitzung der wenigstens einen Komponente abzielen, sondern zudem eine Optimierung im Hinblick auf die Gesamtdauer des Messprotokolls und/oder die Bildqualität umfassen.

Wesentlichen Einfluss auf die Fragestellung, ob eine Überhitzung bei Abarbeitung eines Messprotokolls mit einer Magnetresonanzeinrichtung auftritt, hat, in welchem Temperaturzustand, insbesondere hinsichtlich der Temperatur der wenigstens einen Komponente, sich die Magnetresonanzeinrichtung zu Beginn der Durchführung des Messprotokolls befindet. Daher werden in einem Schritt S1 des in Fig. 1 dargestellten Ausführungsbeispiels zunächst Vorgabeinformationen 1 genutzt, um Temperaturzustandsklassen zu definieren, für welche Einstellungsparametersätze bestimmt werden sollen. Temperaturzustandsklassen sind dabei insbesondere Bereiche von Temperaturzuständen, im Fall der Betrachtung einer einzelnen Komponente und deren Temperatur beispielsweise Temperaturbereiche der Komponente. Allgemein gesagt können Temperaturzustandsklassen beispielsweise den Bereich von Temperaturzuständen der Magnetresonanzeinrichtung von "kalt" zu "heiß" in entsprechende Unterbereiche unterteilen. Die Vorgabeinformationen 1, deren Nutzung allgemein gesprochen optional, jedoch bevorzugt ist, beschreiben anhand von beim Betrieb baugleicher Magnetresonanzeinrichtungen aufgenommenen Daten, welche Temperaturzustände zu Beginn einer Messung mit dem Messprotokoll bereits auftraten, bevorzugt aufgeschlüsselt nach Einsatzklassen der Magnetresonanzeinrichtung. Auf dieser Basis können Temperaturzustandsklassen beispielsweise, insbesondere einsatzklassenspezifisch, so definiert werden, dass eine Temperaturzustandsklasse einen bestimmten Prozentsatz aller aufgetretenen Temperaturzustände umfasst, ausgeschlossen die "heißesten" Temperaturzustände. Auch eine feinere Unterteilung in Temperaturzustandsklassen ist möglich, beispielsweise die 20 % Temperaturzustände mit den niedrigsten Temperaturen, die 50 % Temperaturzustände mit den niedrigsten Temperaturen ohne die untersten 20 %, usw. In jedem Fall ist die Vorgabeinformation 1 dahingehend zweckmäßig, dass Temperaturzustandsklassen definiert werden können, die für die Magnetresonanzeinrichtung tatsächlich relevant sind, beispielsweise eine Art Default-Temperaturzustandsklasse definiert werden kann, für die beispielsweise bei 95 % aller beobachteten Temperaturzustände zu Beginn des Messprotokolls keine Überhitzung zu befürchten ist.

Temperaturzustandsklassen können zusätzlich oder alternativ auch anderweitig definiert werden. Diesbezüglich sei beispielhaft auf die im Vorangehenden bereits dargelegten Beispiele zu den "idealen Anfangsbedingungen", "typischen Anfangsbedingungen" und "Worst-Case-Anfangsbedingungen" verwiesen.

Wenn die Vorgabeinformation 1 nach Einsatzklassen aufgeschlüsselt ist, können auch Temperaturzustandsklassen unterschiedlich für unterschiedliche Einsatzklassen bestimmt werden. Beispielsweise sind für nur sporadisch benutzte Magnetresonanzeinrichtungen die 95% der beobachteten Starttemperaturzustände definierenden Grenzen bei niedrigeren Temperaturen zu suchen als bei stark ausgelasteten Magnetresonanzeinrichtungen oder sogar Forschungsgeräten.

In einem Schritt S2 wird ein Temperaturmodell 2, welches zur Ermittlung der Einstellungsparametersätze verwendet werden soll, kalibriert. Das bedeutet, Modellparameter des Temperaturmodells 2, vgl. beispielsweise die Formeln (4) und (5), dort die Parameter $\tau$ und $\alpha$, können durch Kalibrationsmessungen bestimmt werden, wobei im vorliegenden Fall davon ausgegangen wird, dass die Kühltemperatur Tcool als auslegungsspezifisch und somit bekannt angesehen werden kann. Die Kalibrationsmessung kann gezielt an der Magnetresonanzeinrichtung, also dem entsprechenden Einzelexemplar, erfolgen, für die die Einstellungsparametersätze ermittelt werden sollen, um der Einzelexemplarstreuung Rechnung zu tragen, aber auch über mehrere baugleiche Magnetresonanzeinrichtungen, wobei hier bevorzugt Extremfall-Annahmen getroffen werden. Vorliegend werden in jedem Fall, wie auch bereits zum konkret verwendeten Temperaturmodell 2 gemäß den Formeln (3) bis (5) beschrieben wurde, Zeitkonstanten $\tau$ betrachtet, die deutlich länger als die Zeitstruktur während der Magnetresonanzsequenz sind, insbesondere eine Minute oder mehr betragen, um die Verwendung ermittelter Gradientenstärken, vergleiche Formel (1) oder (2), zu rechtfertigen.

Im Schritt S3 wird das kalibrierte Temperaturmodell 2 dann genutzt, um Einstellungsparametersätze 3 zu ermitteln, die dann in einem Schritt S4 bereitgestellt werden können. Die Einstellungsparametersätze 3 werden dabei so bestimmt, dass für jeden Temperaturzustand, der in einer Temperaturzustandsklasse enthalten ist, eine Überhitzung vermieden wird, so dass sie mithin temperaturzustandsklassenspezifisch ermittelt werden. Dabei wird ferner von einer bestimmten Wiederholungsanzahl ausgegangen, für die das Messprotokoll wiederholt werden kann, wobei im hier beschriebenen Ausführungsbeispiel die Wiederholungsanzahl auf maximal Eins gesetzt wird, da dies dem für viele Messprotokolle am ehesten zutreffenden Fall entspricht. Es sei darauf hingewiesen, dass es grundsätzlich auch denkbar, Einstellungsparametersätze 3 für verschiedene Wiederholungsanzahlen zu bestimmen. Genauso ist es selbstverständlich möglich, Einstellungsparametersätze 3 für unterschiedliche Messprotokolle zu ermitteln und/oder auch einen Einstellungsparametersatz 3 für in jedem Fall nutzbare Vorgaben zu ermitteln, beispielsweise als Rückfalllösung. Ein solcher Einstellungsparametersatz 3 würde dann dem RORE-Fall entsprechen.

Bei der Ermittlung der Einstellungsparametersätze 3 für die unterschiedlichen Temperaturzustandsklassen kann von den extremsten in einer jeweiligen Temperaturzustandsklasse enthaltenen Temperaturzuständen, mithin den die heißesten Temperaturen beschreibenden Temperaturzuständen, ausgegangen werden. Die Ermittlung kann unter zusätzlichen Optimierungskriterien, wie beschrieben insbesondere Minimierung der Gesamtdauer des Messprotokolls und/oder Maximierung der Bildqualität, erfolgen. Es kann iterativ vorgegangen werden, um optimale Kombinationen von Protokollparametern und somit Einstellungsparametern auffinden zu können.

Fig. 2 illustriert ein Ausführungsbeispiel eines erfindungsgemäßen Verfahrens zum Betrieb einer Magnetresonanzeinrichtung, der Einstellungsparametersätze 3 bereitgestellt wurden. In einem Schritt S5 wird dort ein Messprotokoll ausgewählt, mit Hilfe dessen beispielsweise Magnetresonanzdaten eines Patienten aufgenommen werden sollen. Während es denkbar ist, eine vorgegebene Default-Temperaturzustandsklasse zu definieren und den entsprechenden Einstellungsparametersatz 3 auszuwählen, um das Messprotokoll im Schritt S6 gemäß diesen Vorgaben zu parametrisieren, ist es in einem optionalen Schritt S8 auch denkbar, den aktuellen Temperaturzustand der Magnetresonanzeinrichtung festzustellen, um dann den Einstellungsparametersatz 3 auszuwählen, der der Temperaturzustandsklasse zugeordnet ist, in die der aktuelle Temperaturzustand der Magnetresonanzeinrichtung fällt.

In jedem Fall wird der ausgewählte Einstellungsparametersatz 3 im Schritt S6 genutzt, um entsprechende Protokollparameter einzustellen, beispielsweise wenigstens teilweise automatisch und/oder wenigstens teilweise manuell, insbesondere in vorgegebenen Wertebereichen. In einem Schritt S7 können dann die Magnetresonanzdaten mit dem Messprotokoll, die unter Berücksichtigung der Vorgabe des Einstellungsparametersatzes 3 gewählten Protokollparameter genutzt werden, aufgenommen werden. Denkbar ist es auch hier, den optionalen Schritt S8, Ermittlung des aktuellen Temperaturzustand der Magnetresonanzeinrichtung, durchzuführen, um zu überprüfen, ob der aktuelle Temperaturzustand der Magnetresonanzeinrichtung noch immer in der korrekten Temperaturzustandsklasse liegt. Ist dies nicht der Fall, kann beispielsweise ein passender Einstellungsparametersatz 3 einer anderen Temperaturzustandsklasse herangezogen werden, um Anpassungen vorzunehmen und/oder es kann eine Rückfalllösung benutzt werden, beispielsweise ein RORE-Protokoll.

Es sei angemerkt, dass auch eine Instanz des Temperaturmodells 2 an der Magnetresonanzeinrichtung bereitgestellt werden kann. Das Temperaturmodell 2 kann an der Magnetresonanzeinrichtung, die bereits in Betrieb genommen wurde, beispielsweise eingesetzt werden, um eine Überhitzung der wenigstens einen Komponente vermeidende Protokollparameter für benutzerdefinierte Messprotokolle, für die keine Einstellungsparametersätze 3 bereitstehen, zu ermitteln, oder aber um bei nicht durch Temperaturzustandsklassen abgedeckten Temperaturzuständen zu Beginn eines Messprotokolls Anpassungen vornehmen zu können.

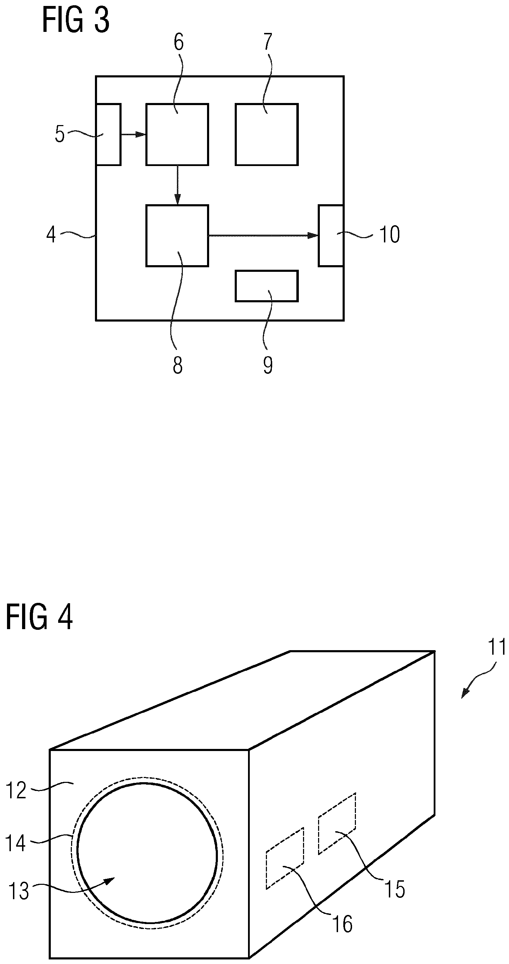

Fig. 3 zeigt eine Prinzipskizze des funktionalen Aufbaus einer erfindungsgemäßen Bereitstellungseinrichtung 4. Diese weist optional eine Schnittstelle 5 für die Entgegennahme der Vorgabeinformation auf. In einer Klassendefinitionseinrichtung 6 können gemäß dem Schritt S1 die Temperaturzustandsklassen definiert werden. Eine Kalibrierungseinheit 7 kann die Kalibrierung des Schrittes S2 steuern beziehungsweise die Ergebnisse der Kalibrationsmessung auswerten. Schließlich ist eine Modellierungseinrichtung 8 zur Anwendung des Temperaturmodells 2, welches in einem Speichermittel 9 gespeichert sein kann, vorgesehen, um gemäß dem Schritt S3 die Einstellungsparametersätze 3 zu ermitteln. Diese können dann über eine entsprechende Schnittstelle 10 zum Bereitstellen der Einstellungsparametersätze 3 bereitgestellt werden.

Fig. 4 zeigt eine Prinzipskizze einer erfindungsgemäßen Magnetresonanzeinrichtung 11. Diese weist, wie grundsätzlich bekannt, eine Hauptmagneteinheit 12 auf, in der der Grundfeldmagnet zur Erzeugung des Grundmagnetfeldes aufgenommen ist. Die Hauptmagneteinheit 12 definiert eine Patientenaufnahme 13, in die über eine hier nicht näher gezeigte Patientenliege ein Patient eingefahren werden kann. Die Patientenliege 13 umgebend ist neben einer hier nicht näher dargestellten Hochfrequenzspulenanordnung eine Gradientenspulenanordnung 14 vorgesehen, welche eine Komponente, deren Überhitzung vermieden werden soll, sein kann. Auch wenigstens eine weitere oder andere Komponente 15 ist in Fig. 4 angedeutet. Der Betrieb der Magnetresonanzeinrichtung 11 wird mittels einer Steuereinrichtung 16 gesteuert.

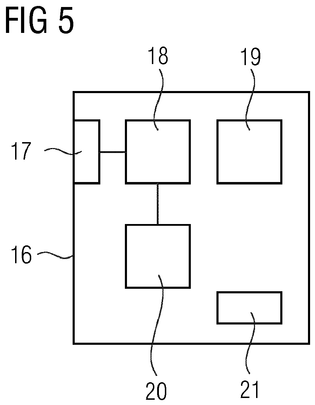

Der funktionale Aufbau der Steuereinrichtung 16 ist in Fig. 5 näher dargestellt. Die Steuereinrichtung 16 umfasst vorliegend eine Schnittstelle 17 zur Entgegennahme von Einstellungsparametersätzen 3 von der Bereitstellungseinrichtung 4. In einer Einstellungseinheit 18 können Einstellungsparametersätze 3 genutzt werden, um gemäß der für sie beschriebenen Vorgaben Messprotokolle zu parametrisieren, mithin deren Protokollparameter entsprechend zu bestimmen. Ein aktueller Temperaturzustand der Magnetresonanzeinrichtung 11 kann beispielsweise durch eine Temperatureinheit 19 festgestellt werden (Schritt S8). Gezeigt ist ferner eine für Magnetresonanzeinrichtungen 11 übliche Sequenzeinheit 20, über die mittels entsprechender Messprotokolle Magnetresonanzdaten aufgenommen werden können.

Auch die Steuereinrichtung 16 kann ein Speichermittel 21 umfassen, in dem auch das Temperaturmodell 2, entsprechend kalibriert für die Magnetresonanzeinrichtung 11, abgespeichert sein kann.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zur Bereitstellung von Einstellungsparametersätzen (3) für wenigstens ein durch Protokollparameter beschriebenes Messprotokoll zur Aufnahme von Magnetresonanzdaten mit einer Magnetresonanzeinrichtung, wobei der Einstellungsparametersatz (3) vorgegebene Werte für wenigstens einen Teil der Protokollparameter und/oder vorgegebene Wertebereiche für wenigstens einen Teil der Protokollparameter umfasst, **dadurch gekennzeichnet, dass** je ein Einstellungsparametersatz (3) für wenigstens zwei Temperaturzustandsklassen der Magnetresonanzeinrichtung unter Verwendung eines die Entwicklung des Temperaturzustands wenigstens einer Komponente (15) der Magnetresonanzeinrichtung, die bei der Ausführung des Messprotokolls erwärmt wird, während der Ausführung des Messprotokolls beschreibenden Temperaturmodells (2) derart ermittelt wird, dass für jeden Starttemperaturzustand, der in der Temperaturzustandsklasse enthalten ist, zu Beginn einer Messung mit einem Messprotokoll, das Protokollparameter gemäß den Vorgaben des Einstellungsparametersatzes (3) nutzt, eine Überhitzung, beschrieben durch Überschreitung einer Grenztemperatur, der wenigstens einen Komponente (15) durch die maximal für eine vorgegebene Wiederholungsanzahl wiederholte Messung mit dem Messprotokoll vermieden wird.

2. Verfahren nach Anspruch 1, **dadurch gekennzeichnet, dass** die Temperaturzustandsklassen durch Auswertung von bei Nutzung einer zumindest im Wesentlichen baugleichen Magnetresonanzeinrichtung ermittelte Starttemperaturzustände für das Messprotokoll beschreibenden Vorgabeinformationen (1) definiert werden.

3. Verfahren nach Anspruch 2, **dadurch gekennzeichnet, dass** die Vorgabeinformationen (1) nach wenigstens einer Einsatzklasse aufgeschlüsselt vorliegen, wobei die Auswertung und/oder die Definition der Temperaturzustandsklassen in Abhängigkeit der Einsatzklassen erfolgt.

4. Verfahren nach Anspruch 2 oder 3, **dadurch gekennzeichnet, dass** wenigstens ein Teil der Temperaturzustandsklassen derart bestimmt ist, dass ein vorgegebener, Starttemperaturzustände mit den höchsten Temperaturen ausschließender Anteil der insbesondere einsatzklassenspezifisch betrachteten Starttemperaturzustände der Vorgabeinformation (1) enthalten ist.

5. Verfahren nach einem der vorangehenden Ansprüche, **dadurch gekennzeichnet, dass** wenigstens ein Teil der Temperaturzustandsklassen durch Schwellwerte für die Temperatur der wenigstens einen Komponente (15) definiert wird, wobei insbesondere die Schwellwerte wenigstens teilweise abhängig von einer Kühltemperatur, auf die die Komponente (15) mittels einer dieser zugeordneten Kühleinrichtung gekühlt wird, und/oder der Grenztemperatur gewählt werden.

6. Verfahren nach einem der vorangehenden Ansprüche, **dadurch gekennzeichnet, dass** wenigstens ein Teil der Temperaturzustandsklassen in Abhängigkeit von einem Betrieb der Magnetresonanzeinrichtung in einem unmittelbar zu Beginn des Messprotokolls endenden Zeitabschnitt definiert sind.

7. Verfahren nach einem der vorangehenden Ansprüche, **dadurch gekennzeichnet, dass** ein lineares Temperaturmodell (2) verwendet wird, bei dem in einer Differentialgleichung ein linearer Zusammenhang zwischen der Temperatur und ihrer zeitlichen Ableitung über eine Zeitkonstante angenommen wird und eine den Leistungseintrag berücksichtigende Energiebilanz gebildet wird.

8. Verfahren nach Anspruch 7, **dadurch gekennzeichnet, dass** die Zeitkonstante größer als eine Minute ist, wobei insbesondere der Leistungseintrag als proportional zu einer mittleren Gradientenleistung, insbesondere einer mittleren quadratischen Gradientenstärke, angenommen wird.

9. Verfahren nach einem der vorangehenden Ansprüche, **dadurch gekennzeichnet, dass** wenigstens ein Modellparameter des Temperaturmodells (2), insbesondere umfassend die Zeitkonstante, in einer Kalibrierungsmessung mit der Magnetresonanzeinrichtung ermittelt wird, wobei insbesondere eine eine bekannte mittlere Gradientenleistung eintragende Magnetresonanzsequenz verwendet wird.

10. Verfahren zum Betrieb einer Magnetresonanzeinrichtung zur Aufnahme von Magnetresonanzdaten mit einem durch Protokollparameter beschriebenen Messprotokoll, aufweisend folgende Schritte:

- Bereitstellen vom Einstellungsparametersätzen (3) durch ein Verfahren nach einem der vorangehenden Ansprüche,
- Ermittlung von Protokollparametern für das Messprotokoll gemäß der Vorgabe eines für das Messprotokoll bereitgestellten Einstellungsparametersatzes (3),
- Aufnahme der Magnetresonanzdaten unter Verwendung der ermittelten Protokollparameter.

11. Verfahren nach Anspruch 10, **dadurch gekennzeichnet, dass** der Einstellungsparametersatz (3) in Abhängigkeit der Zugehörigkeit des Temperaturzustands zu Beginn des Messprotokolls zu einer Temperaturzustandsklasse und/oder der Zugehörigkeit der Magnetresonanzeinrichtung zu einer Einsatzklasse gewählt wird.

12. Verfahren nach Anspruch 10 oder 11, **dadurch gekennzeichnet, dass** der tatsächliche, aktuelle Temperaturzustand vor dem Start der Messung mit dem Messprotokoll ermittelt wird, wobei dann, wenn der aktuelle Temperaturzustand nicht Teil der Temperaturzustandsklasse des genutzten Einstellungsparametersatzes (3) ist, die ermittelten Protokollparameter durch Nutzung eines der Temperaturzustandsklasse, der der aktuelle Temperaturzustand angehört, zugehörigen Einstellungsparametersatzes (3) und/oder durch Berechnung unter Benutzung des Temperaturmodells (2) derart, dass eine Überhitzung der wenigstens einen Komponente (15) vermieden wird, angepasst werden.

13. Bereitstellungseinrichtung (4) zur Durchführung eines Verfahrens nach einem der Ansprüche 1 bis 9, aufweisend eine Klassendefinitionseinrichtung (6) zur Definition der Temperaturzustandsklassen, eine Modellierungseinrichtung (8) zur Ermittlung von Einstellungsparametersätzen (3) und eine Schnittstelle (10) zum Bereitstellen der Einstellungsparametersätze (3).

14. Magnetresonanzeinrichtung (11), aufweisend eine zur Durchführung eines Verfahrens nach einem der Ansprüche 10 bis 12 ausgebildete Steuereinrichtung (16).

15. Computerprogramm, welches die Schritte eines Verfahrens nach einem der Ansprüche 1 bis 9 oder einem der Ansprüche 10 bis 12 durchführt, wenn es auf einer Recheneinrichtung ausgeführt wird.

## FIG 1

## FIG 2

FIG 3

FIG 4

# FIG 5

**Europäisches Patentamt**
**European Patent Office**
**Office européen des brevets**

# EUROPÄISCHER RECHERCHENBERICHT

Nummer der Anmeldung

EP 19 19 9598

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X<br>A | US 2015/123661 A1 (YUI MASAO [JP] ET AL) 7. Mai 2015 (2015-05-07)<br>* Abbildungen 1,2,3,4,5 *<br>* Absatz [0013] - Absatz [0094] *<br>----- | 1-11, 13-15<br>12 | INV.<br>G01R33/54 |
| X<br>A | US 2017/045590 A1 (TAKAI YUKI [JP] ET AL) 16. Februar 2017 (2017-02-16)<br>* Abbildungen 1,2,4,5,6 *<br>* Absatz [0030] - Absatz [0098] *<br>----- | 1-9,13, 15<br>12 | |
| X<br>A | JP H08 56917 A (GE YOKOGAWA MED SYST LTD) 5. März 1996 (1996-03-05)<br>* Absatz [0025] - Absatz [0062] *<br>----- | 1,2,4-9, 13,15<br>12 | |
| A | CHU K C ET AL: "MR Gradient Coil Heat Dissipation",<br>MAGNETIC RESONANCE IN MEDICINE, JOHN WILEY & SONS, INC, US,<br>Bd. 34, Nr. 1, 1. Juli 1995 (1995-07-01), Seiten 125-132, XP002255178,<br>ISSN: 0740-3194<br>* Abbildung 4 *<br>* Abschnitt "THEORY" *<br>* Abschnitt "DISCUSSION OF THEORY" *<br>----- | 1-15 | RECHERCHIERTE SACHGEBIETE (IPC)<br><br>G01R |
| A | EP 3 454 071 A1 (SIEMENS HEALTHCARE GMBH [DE]) 13. März 2019 (2019-03-13)<br>* Absatz [0019] - Absatz [0020] *<br>* Abbildung 1 *<br>* Absatz [0039] - Absatz [0065] *<br>----- | 1-15 | |

Der vorliegende Recherchenbericht wurde für alle Patentansprüche erstellt

| Recherchenort | Abschlußdatum der Recherche | Prüfer |
|---|---|---|
| München | 30. März 2020 | Durst, Markus |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 19 19 9598

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-03-2020

| Im Recherchenbericht angeführtes Patentdokument | Datum der Veröffentlichung | Mitglied(er) der Patentfamilie | Datum der Veröffentlichung |
|---|---|---|---|
| US 2015123661 A1 | 07-05-2015 | JP 2015085137 A<br>US 2015123661 A1 | 07-05-2015<br>07-05-2015 |
| US 2017045590 A1 | 16-02-2017 | JP 6615530 B2<br>JP 2017035306 A<br>US 2017045590 A1 | 04-12-2019<br>16-02-2017<br>16-02-2017 |
| JP H0856917 A | 05-03-1996 | KEINE | |
| EP 3454071 A1 | 13-03-2019 | EP 3454071 A1<br>US 2019072624 A1 | 13-03-2019<br>07-03-2019 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 19152127